Europäisches Patentamt

European Patent Office

Office européen des brevets

(11) Publication number: **0 354 027**
A2

# EUROPEAN PATENT APPLICATION

(21) Application number: 89307883.2

(22) Date of filing: 03.08.89

(51) Int. Cl.⁵: **C 11 D 7/50**
C 11 D 7/24, C 11 D 7/26,
C 23 G 5/00

(30) Priority: 04.08.88 US 229183

(43) Date of publication of application:
07.02.90 Bulletin 90/06

(84) Designated Contracting States:
AT BE CH DE ES FR GB GR IT LI LU NL SE

(71) Applicant: ENVIROSOLV INC.
1840 Southside Boulevard
Jacksonville Florida 32216 (US)

(72) Inventor: Klopfenstein, Robert L.
20968 Delgado Terrace
Boca Raton Florida 33433 (US)

(74) Representative: Lawrence, Peter Robin Broughton et al
GILL JENNINGS & EVERY 53-64 Chancery Lane
London WC2A 1HN (GB)

(54) Biodegradable, non-toxic, nonhazardous solvent composition.

(57) A biodegradable, non-toxic, non-hazardous solvent composition comprises a mixture of a major amount of para-menthadienes and a minor amount of terpene alcohols.

**Description**

## BIODEGRADABLE, NON-TOXIC, NON-HAZARDOUS SOLVENT COMPOSITION

The present invention is directed to a new, biodegradable, non-toxic, non-hazardous solvent composition based upon certain mixtures of selected cyclic terpenes. More specifically, the solvent composition of the present invention is based on the use of a mixture of cyclic terpenes and preferably a mixture of a major amount of para-menthadienes and a minor amount of terpene alcohol.

The present invention is a result of a recent application of chemical technology which has led to the development of a new family of chemical products which have exciting potential as solvents for business and industry. The cyclic terpenes used in the solvent compositions are found in nearly all living plants and other organic products and are totally biodegradable. Consequently the solvent compositions of the present invention may be flushed with water into municipal sewer systems. Moreover, the solvent compositions of the present invention exhibit superior solvency characteristics and may be used in many cleaning, de-greasing and cutting applications previously performed only by chlorinated solvents and similar traditional solvent products. These traditional solvents, almost without exception, are toxic, require special handling and administrative compliance procedures, and many are carcinogenic.

### BACKGROUND OF THE INVENTION

Legislation enacted over the past decade has made the use of traditional solvent materials a problem area for most business and industry. The products are toxic, and therefore require most or all of the following precautions:

1. Special storage requirements.
2. Special use and handling instructions.
3. Special transportation rules and documentation.
4. Disposal by a licensed waste hauler into a controlled landfill.
5. Extensive documentation, special hazardous material training programs, action plans for spills and cleanup, and extensive government reporting.
6. Increased liability insurance coverage.

The cost to American business and industry because of the special handling requirement is staggering; the cost to the environment is tremendous (the long term effects are not fully known) with spills, leaks and vapors vented into the atmosphere; and the cost to the American worker who must use these products is the risk to his health because, after all, these products are toxic. Historically, however, for most applications there have been no alternatives, consequently we have had to continue with the hazardous products.

In recent years there has been a trend on the part of the EPA and other federal and state regulatory agencies to reduce and perhaps eventually eliminate business' and industries' reliance on traditional solvent products. The method of doing this is to establish threshold limit values (TLV) and reportable quantities which enter the environment. It is believed that eventually absolute limits of emissions will be established. Products which are non-hazardous and non-toxic are playing an increasingly important role as replacements for traditional solvents.

### BRIEF DESCRIPTION OF THE PRESENT INVENTION

The present invention is based on the discovery that mixtures of selected cyclic terpenes, and specifically mixtures consisting essentially of a major amount of para-menthadienes and a minor amount of terpene alcohols may be formulated to provide solvent compositions which are non-toxic, non-hazardous and bio-degradable and which perform a wide variety of cleaning tasks traditionally performed only by solvents which are toxic and listed as hazardous materials on the U.S. Department of Labor Occupational Safety and Health Administration's Hazard Communication Guide: Subpart Z - Toxic and Hazardous Substances.

Some of the uses contemplated for the solvent compositions of the present invention are:

A. Cold-Tank Degreasing
  1. Metal Parts Cleaning
    a. Transportation Industry
    b. Heavy Equipment
    c. Metal Fabricating
    d. Printing Equipment
B. Electrical Parts Cleaning
  1. Electric Motor Degreasing
  2. Circuit Board Cleaning
C. Adhesive Removal
D. Cosmoline Removal (Imported Automobiles)
E. Ink (Printers Ink) Removal
F. Graffiti Removal
G. Carpet and Fabric Spotter
H. Hot-Tank Degreasing (diluted with water)

As mentioned previously, the organic nature of this product with its biodegradability and non-toxic characteristics make it unique as compared to traditional chlorinated solvents. The non-hazardous and non-toxic characteristic of the solvent composition of the present invention is demonstrated by the fact that none of the ingredients used in the various compositions are listed on either the U.S. Department of Labor Occupational Safety and Health Administration's Hazard Communication Guide: Subpart Z - Toxic and Hazardous Substances or the U.S. Environmental Protection Agency's Section 313 of the Community Right-to-Know Act (Title III of the Superfund Amendments and Reauthorization Act of 1986). These documents are the chemical industry official lists for hazardous and toxic materials respectively. By definition, exclusion from the lists means the mixture is non-reportable and therefore non-hazardous and non-toxic.

Further technical testing supports the non-toxic claim in that a chemical industry standard test, the LD-50 test shows the ingredients to be non-toxic. The LD-50 test determines a lethal dose where 50% of the sample population dies - typically rats. Test results of 2,000 mg per Kg or higher are considered to show the tested material to be non-toxic. All ingredients in the mixture have test results equal or greater than 2,000 mg per Kg.

## DETAILED DESCRIPTION OF THE PRESENT INVENTION

The solvent compositions of the present invention comprise at least 80% by weight of a mixture of selected cyclic terpenes.

The cyclic terpene mixtures used in the solvent composition of the present invention include a major amount of para-menthadienes and a minor amount of terpene alcohols. Preferably the cyclic terpene mixture contains from about 55% to about 90% by weight of para-menthadienes and from about 10% to about 40% of terpene alcohols. The mixture may also contain up to about 5% of other terpene hydrocarbons. It is most preferred that the cyclic terpene mixture contain between about 60% and 80% by weight of para-menthadienes, along with up to 5% by weight of other terpene hydrocarbons, and between about 10% and 35% by weight of terpene alcohols.

Para-menthadienes are a genus of cyclo-aliphatic terpene hydrocarbons ($C_{10}$-$H_{16}$) which include a mixture of isomers. Para-menthadienes may be derived from a variety of natural sources and found in a variety of commercial products.

One commercial source of para-menthadienes is a product called TABS-D which is available from Union Camp Corporation, Jacksonville, Florida. TABS-D contains approximately 95% para-menthadienes and about 5% of other terpene hydrocarbons. It possesses the following physical characteristics:

| | |
|---|---|
| Aniline Point | 5°F |
| Distillation Range | 173°C-185°C |
| Flash Point (closed cup) | 123°F |
| Kauri Butanol Value | 67 ml |
| Solubility in Water | <0.2% |
| Specific Gravity (20°F) | 0.8565 |
| Vapor Pressure (@ 68°F) | <3 mm Hg |

The terpene alcohols used in the mixtures of the present invention may be derived from a variety of sources. There are many commercially available products which contain suitable terpene alcohols in suitable quantities. Some suitable products are:

A product called Glidsol 150 which is available from Glidco Organics, Jacksonville, Florida. Glidsol 150 is a mixture of terpene alcohols ($C_{10}H_{16}O$) containing 39.6% plinols, 24.1% pinanols, 9.7% linalool, 4.2% 3-pinanols, 1.6% terpinol and 1.6% nerol. An essentially identical product is also sold under the name Glidsol 175. It possesses the following physical characteristics:

| | |
|---|---|
| Specific Gravity 15.5° | 0.919 |
| Refractive Index 20°C | 1.471 |
| Distillation Range °C | 194-207 |
| Kauri Butanol Value | >500 |
| Flash Point (closed cup) | 164°F |
| Solubility Parameter | 9.5 |

A product called Unipine 90, which is available from Union Camp Corporation, is a suitable source of terpene alcohol. It is made up of approximately 82% terpineol, 15% by weight of other terpene alcohols and 3% by weight of terpene hydrocarbons. The chemical formula is ($C_{10}H_{18}O$).
The physical characteristics are as follows:

| | |
|---|---|
| Refractive Index | 1.477 |
| Flash Point (closed cup) | 188°F |
| Kauri Butanol Value | >500 |
| Distillation Range °C | 206-222 |

A product called Glidcol 95 which is available from Glidco Organics, Jacksonville, Florida. Glidcol 95 contains mostly terpineol ($C_{10}H_{18}O$), i.e., about 62.0% terpineol, 35.0% mixture of other terpene alcohols, and 3.0% mixture of terpene hydrocarbons. It possesses the following physical characteristics:

| | |
|---|---|
| Refractive Index 20°C | 1.47-1.49 |
| Flash Point (closed cup) | 184°F |
| Kauri Butanol Value | >500 |
| Distillation Range °C | 212-222 |

## BIODEGRADABLE SURFACTANTS

For some uses it is desirable to include in the composition emulsifiers and/or wetting agents (hereinafter referred to as surfactants) which fulfill their well known properties when used in solvents of the type herein described. The present invention contemplates the addition of anionic surfactants, non-ionic surfactants or cationic surfactants to the mixture of cyclic terpenes described above, although the anionics are preferred. Generally the addition of up to 10% by weight of the composition of surfactants is preferred.

It has been found helpful to add surfactants to solvent compositions which are to be used in combination with a water rinse. It has been found that the addition of the surfactant to the cyclic terpene mixture enhances the water rinsability of the solvent composition. Further, it has been found that in dealing with certain types of soil, the addition of a surfactant to the mixture of cyclic terpenes enhances the ability of the cyclic terpene mixture to remove the soil from the substrate.

Suitable anionic surfactants, which may be used with the cyclic terpene mixtures, include salts of higher alkylaryl sulfonates, with preferred anionics being the alkali metal and amine salts of dodecyl benzene sulfonic acid. A preferred anionic surfactant is calcium dodecyl benzene sulfonate, which is commercially available under the trade name Toximul from Stephan Chemical Company, Chicago, Illinois. Toximul has the following physical characteristics:

| | |
|---|---|
| Boiling Point | 212°F |
| Vapor Pressure (mm Hg) | 17 |
| Vapor Density (air = 1) | 0.62 |
| Specific Gravity @ 25°C | 1.032 |

Suitable non-ionic surfactants, which may be used with the cyclic terpene mixture, include condensates of hydrophobic moieties with polymeric lower alkylene oxides, the preferred type of non-ionic being alkylphenol ethylene oxide condensates containing 4 to 15 moles of ethylene oxide.

Among the preferred cationic emulsifiers and wetting agents are tall oil fatty acids, triethanolamine, diethanolamine and mixtures thereof.

A product commonly called Pamak 4 Tall Oil Fatty Acid, available from Hercules Incorporated, Wilmington, Delaware, is a useful tall oil fatty acid, a composition primarily of 51% oleic acid (CAS #112-80-1) $C_{18}H_{34}O_2$, 45% linoleic acid (CAS #60-33-3) $C_{18}H_{32}O_2$, and 4% saturated acids. It possesses the following physical characteristics:

| | |
|---|---|
| Color (Gardner) | 6 |
| Acid Value | 188 |
| Iodine Value | 130 |
| Titer, °C | 12 |
| Specific Gravity @ 25°C | 0.906 |
| Wt. per Gallon, 25°C, Lbs. | 7.53 |
| Viscosity, Gardner-Holdt, 25°C | A |
| Viscosity, SUS, 100°F | 100 |
| Flash Point (open cup) | 380°F |

A product commonly called TEA-85, available from Union Carbide Corporation, Danbury, Connecticut, is a useful triethanolamine mixture (CAS #102-71-6) $(HOC_2H_4)_3N$ - containing 85% triethanolamine and 15% diethanolamine. It possesses the following physical characteristics:

| | |
|---|---|
| Specific Gravity @ 20°C | 1.123 |
| Boiling Point | 123°C |
| Vapor Density | 5.1 |
| Pour Point | -5°C |
| Vapor Pressure @ 20°C | 5 mm Hg |
| Solubility in Water @ 25°C | 100% |
| Evaporation Rate | 0.53 |

Triethanolamine oleate made from the reaction of triethylamine and oleic acid to form a neutral soap with less than 0.5% free amine and no free acid may also be used. Most of these surfactants may be used in concentrations from 0.1% to 10%, but generally should not exceed 10%.

Ethoxylated primary and secondary alcohols also may be used as surfactants. Particularly preferred are the $C_{12}$-$C_{14}$ alcohols having between 4 and 10 moles of ethoxylation. Also useful are the alkyl phenol (polyethoxy) ethanols which have alkyl carbon chains of $C_8$ to $C_{16}$ with 4 to 12 moles of ethyleneoxide.

The compositions of the present invention are preferably essentially non-aqueous, because these compositions are stable liquids in the absence of added water. However, the compositions of the present invention may be diluted with water, to form emulsions, prior to use for some purposes. It is not desired to include water in the compositions as fabricated because of a significant decrease in performance.

The following Examples will serve to illustrate the preparation of several compositions within the scope of the present invention. It is understood, however, that these Examples are set forth merely for illustrative purposes and that many other compositions are within the scope of the present invention. Moreover, other methods of mixing and other techniques for use are contemplated by the present invention. Those skilled in the art will recognize that a wide variety of compositions containing cyclic terpenes may be similarly prepared and used.

### Example I

The following solvent compositions are specifically designed for the printing ink industry and for removal of inks from printing presses and for the cleaning of mixing tanks and filling equipment, in plants which produce printers' inks.

The ingredients used in the order of addition of those ingredients in the formulation are shown below. The specific amount of each ingredient is given as a percentage of weight of the finished product.

High Solvency Formula A
70.0% TABS-D
15.0% Glidsol 150
15.0% Glidcol 95

High Flash-Point Formula B
75.0% TABS-D
15.0% Glidsol 150
10.0% Glidcol 95

Best All Purpose Formula C
80.0% TABS-D
10.0% Glidsol 150
10.0% Glidcol 95

The cyclic terpene components in Formulas A, B and C are shown in Table I.

TABLE I

|  | A | B | C |
|---|---|---|---|
| Para-menthadienes | 66.5 % | 71.25% | 76 % |
| Terpene Alcohols | 29.55% | 24.7 % | 19.7% |
| Other Terpene Hydrocarbons | 3.95% | 4.05% | 4.3% |

The specific procedure to be followed in the above solvent composition is as follows:

1) Addition of materials to a stainless steel mixing tank in the order shown.

2) Temperature of the ingredients should fall in the range of 15.6°C to 32.2°C.

3) Agitation is performed by a high speed mixer of not less than 100 rpm for a period of 30 minutes.

4) Finished mixture for Example I is removed directly into appropriate DOT approved container for shipment.

The solvent compositions of Example I may be applied to the surface to be cleaned manually with a rag or sponge or they may be sprayed on the surface to be cleaned with a trigger sprayer, pump-up pressure sprayer or compressed air spraying equipment. Light agitation of the surface to be cleaned may be required depending on the soil level. The temperature of the surface to be cleaned should be in a range of 20°F to 150°F. The surface to be cleaned may be wiped dry with a clean cloth or allowed to air dry. The resultant dirty solvent from the cleaning process may be sewered with water to a municipal sewer system.

Testing of the solvent composition of Example I was performed by a major U.S. producer of printing ink and the cleaning performance characteristics were found to be equal to or greater than the performance of the historically used toxic and hazardous solvent.

## EXAMPLE II

The solvent compositions of Example II are designed for general purpose degreasing of metal parts and metal machinery and will be used by industrial manufacturers, re-manufacturers and repair shops, and the machine tool industry.

The ingredients used and the order of addition of those ingredients are shown below. The mixing procedure of Example I was followed. The specific amount of each ingredient is shown as a percentage of weight of the finished product.

High Solvency Formula A
60.0% TABS-D
15.0% Glidsol 150
15.0% Glidcol 95
5.0% TEA-Oleate
5.0% Pamak 4

High Flash-Point Formula B
65.0% TABS-D
15.0% Glidsol 150
10.0% Glidcol 95
5.0% TEA-Oleate
5.0% Pamak 4

Best All Purpose Formula C
70.0% TABS-D
10.0% Glidsol 150
10.0% Glidcol 95
5.0% TEA-Oleate
5.0% Pamak 4

The cyclic terpene components in Formulas A, B and C are shown in Table II.

TABLE II

|  | A | B | C |
|---|---|---|---|
| Para-menthadienes | 57 % | 61.75% | 66.5% |
| Terpene Alcohols | 29.55% | 24.7 % | 19.7% |
| Other Terpene Hydrocarbons | 3.45% | 3.55% | 3.8% |
| TEA-Oleate | 5 % | 5 % | 5 % |
| Tall Acid Fatty Acids | 5 % | 5 % | 5 % |

The solvent compositions of Example II may be applied to the surface to be cleaned manually with a rag or sponge or they may be sprayed on the surface to be leaned with a trigger sprayer, pump-up pressure sprayer or compressed air spraying equipment. Small piece parts may be dipped into a container containing the solvent composition of Example II. Light agitation of the surface to be cleaned with a brush or rag may be required depending on the soil level. The temperature of the surface to be cleaned should be in a range of 20°F to 150°F. The surface to be cleaned may be wiped dry with a clean cloth or allowed to air dry. The resultant dirty solvent from the cleaning process may be sewered with water to a municipal sewer system.

Testing of the solvent composition of Example II was performed on a variety of metal components, including automobile engine and brake parts, bicycle parts and also by a major aluminum fishing boat manufacturer and the cleaning performance characteristics were found to be equal to or greater than the performance of the historically used solvent, which in the case of the boat manufacturer was toulene, a known carcinogen.

## EXAMPLE III

The solvent composition of Example III is specifically designed for cleaning carpets and fabrics and for use by professional carpet and upholstery cleaners and by dry cleaners for fabric spotting.

The ingredients used and the order of addition of those ingredients as follows. The mixing procedure of Example I was followed. The specific amount of each ingredient is given as a percentage of weight of the finished product.

Best All Purpose Formula
70.0% TABS-D
10.0% Glidsol 150
10.0% Glidcol 95
5.0% TEA-Oleate
5.0% Pamak 4

The cyclic terpene components and other organic components are shown in Table III.

TABLE III

| Para-menthadienes | 66.5% |
|---|---|
| Terpene Alcohols | 19.7% |
| Other Terpene Hydrocarbons | 3.8% |
| TEA-Oleate | 5 % |
| Tall Acid Fatty Acids | 5 % |

The solvent composition of Example III may be applied to the carpet or fabric to be spot cleaned manually with a rag or sponge or it may be sprayed on the surface to be cleaned with a trigger sprayer, pump-up pressure sprayer or compressed air spraying equipment. Light agitation of the carpet or fabric to be cleaned with a brush or rag may be required depending on the soil level. The fabric should be allowed to air dry. After spotting with the solvent composition of Example III, the carpet or fabric may be cleaned with any conventional or generally accepted method. The resultant dirty solvent from the cleaning process may be sewered with water to a municipal sewer system.

Testing of the solvent composition of Example III was performed on a variety of carpet types and upholstered fabrics containing grease, tar and asphalt from a recently paved street and it was found that the cleaning performance characteristics were superior to traditional dry cleaning spotting solvents.

EXAMPLE IV

This solvent composition of Example IV is for cleaning electrical components, electric motors and printed circuit boards and will be used by electrical manufacturers, electrical maintenance and repair facilities, electric circuit board manufacturers and electronic equipment maintenance companies.

The ingredients used and the order of addition of those ingredients are as follows.

The mixing procedure of Example I was followed. The specific amount of each ingredient as a percentage of weight of the finished product mixture is identified in the following specific solvent composition:

Best All Purpose Solvent Composition
70.0% TABS-D
20.0% Glidsol 150
10.0% Glidcol 95

TABLE IV

| Para-menthadienes | 66.5% |
|---|---|
| Terpene Alcohols | 39.4% |
| Other Terpene Hydrocarbons | 4.1% |

The solvent composition of Example IV may be applied to the surface to be cleaned manually with a rag or sponge or it may be sprayed on the surface to be cleaned with a trigger sprayer, pump-up pressure sprayer or compressed air spraying equipment. Electrical component parts and electric motors may be dipped into a container containing the solvent composition of Example IV. Electric motors may be running when immersed in the solution as the solvent composition of Example IV has a high flash point and has a high dielectric strength. Light agitation of the surface to be cleaned with a brush or rag may be required depending on the soil level. The temperature of the surface to be cleaned should be in a range of 20°F to 180°F. The surface to be cleaned may be wiped dry with a clean cloth or allowed to air dry. The resultant dirty solvent from the cleaning process may be sewered with water to a municipal sewer system.

EXAMPLE V

This provided the following chemical composition:
90% TABS-D
10% Glidsol 150

TABLE V

| Para-menthadienes | 85.5% |
|---|---|
| Terpene Alcohols | 10 % |
| Other Terpene Hydrocarbons | 4.5% |

EXAMPLE VI

84% TABS-D
10% Glidsol 150
6% Toximul

TABLE VI

| Para-menthadienes | 79.8% |
|---|---|
| Terpene Alcohols | 10 % |
| Other Terpene Hydrocarbons | 4 % |
| Calcium Dodecyl Benzene Sulfonic Acid | 6 % |

SOLVENT COMPOSITIONS CONTAINING
N-METHYLPYRROLIDONE

For certain jobs, it has been found that the addition of N-Methylpyrrolidone to cyclic terpene mixtures described above can be used to clean substrates which are not readily cleanable by the cyclic terpene alcohol mixture alone. It is believed that N-Methylpyrrolidone functions as a co-solvent to the cyclic ter pene mixtures described above, and the combination can be used to provide enhanced cleaning of certain substrates, as compared to the cyclic terpene mixture alone. Generally, it has been found that compositions which include from about 10% to about 50% of N-Methylpyrrolidone with the balance being the cyclic terpene mixture described above provides effective results.

N-Methylpyrrolidone is available from a number of sources. A product known as M-Pyrol, available from GAF Chemicals, Wayne, New Jersey, is one such product. The M-Pyrol has the following physical characteristics:

| | |
|---|---|
| Boiling Point | 202°C |
| Vapor Density (air = 1) | 3.4 |
| Freezing Point | -24°C |
| Specific Gravity @ 25°C | 1.027 |
| Flash Point (closed cup) | 199°F |

The N-Methylpyrrolidone containing products are useful in the following applications:

1. Fiberglass Industry - Traditionally, companies which use fiberglass in the manufacturing process (i.e., tanks, panels, automobile parts, etc.) have used Acetone as a clean-up solvent. Acetone is very effective on uncured fiberglass, but is listed by the EPA on Section 313 as a toxic material and is also very hazardous and flammable as the flash point of Acetone is-4°F. This composition is an effective substitute for Acetone in the fiberglass industry.

2. Silk Screen Industry - Certain resins used in the printing of billboards and other silk screen applications are not effectively dissolved by traditional aliphatic or aromatic sol vents and typically use esters, ethers or ketones for this purpose. These types of solvents are generally considered as toxic and hazardous substances. This composition is effective in cleaning resin based inks in the silk screen and other printing applications.

3. Silicone Industry - Silicone manufacturers use 1,1,1 Trichloroethane as a clean-up solvent as it is the most effective at removing cured silicone material from metal tanks, objects and tools. 1,1,1 Trichloroethane is listed as a toxic substance on the EPA Section 313 list. This composition is an effective replacement for 1,1,1 Trichloroethane in this application.

The solvent compositions may be applied to the surface to be cleaned manually with a rag or sponge or they may be sprayed on the surface to be cleaned with a trigger sprayer, pump-up pressure sprayer or compressed air spraying equipment. Small piece parts may be dipped into a container containing the solvent composition of Example II. Light agitation of the surface may be cleaned with a brush or rag may be required depending on the soil level. The temperature of the surface to be cleaned should be in a range of 20°F to 150°F. The surface to be cleaned may be wiped dry with a clean cloth or allowed to air dry.

The specific procedure to be followed in the above solvent composition is as follows:

1) Addition of materials to a stainless steel mixing tank in the order shown.

2) Temperature of the ingredients should fall in the range of 60°F to 90°F.

3) Agitation is performed by a high speed mixer of not less than 100 rpm for a period of 30 minutes.

4) Finished mixture is removed directly into appropriate DOT approved container for shipment.

## EXAMPLE VII

Example VII illustrates one useful formula which includes N-Methylpyrrolidone.

High Solvency Formula
50% TABS-D
10% Glidsol 175
40% M-Pyrol

This provided a mixture containing the following chemioal composition:

| | |
|---|---|
| Para-menthadienes | 47.5% |
| Terpene Alcohols | 10 % |
| Other Terpene Hydrocarbons | 2.5% |
| N-Methylpyrrolidone | 40 % |

## EXAMPLE VIII

Another formula containing N-Methylpyrrolidone co-solvent is:
60% TABS-D
20% Glidsol 175
20% M-Pyrol

Example VIII provided a composition which included the following:

| | |
|---|---|
| Para-menthadienes | 57% |
| Terpene Alcohols | 20% |
| Other Terpene Hydrocarbons | 30% |
| N-Methylpyrrolidone | 20% |

The fact that the present invention is non-hazardous and non-toxic is proved by the fact that none of the ingredients used in the various mixtures are listed on either the U.S. Department of Labor Occupational Safety and Health Administration's Hazard Communication Guide: Subpart Z - Toxic and Hazardous Substances or the U.S. Environmental Protection Agency's Section 313 of the Community Right-to-Know Act (Title III of the Superfund Amendments and Reauthorization Act of 1986).

These documents are the chemical industry's official lists for hazardous and toxic materials, respectively. By definition, exclusion from the lists means the mixture is non-reportable and therefore non-hazardous and non-toxic.

The forms of invention herein shown and described are to be considered only as illustrative. It would be apparent to those skilled in the art that numerous modifications may be made therein without departure from the spirit of the invention or the scope of the appended claims.

## Claims

1. A biodegradable, non-toxic, non-hazardous solvent composition comprising a mixture of a major amount, by weight, of para-menthadienes, and a minor amount of terpene alcohols.

2. A composition according to claim 1 also comprising a minor amount of other terpene hydrocarbons.

3 A composition according to claim 1 or claim 2, comprising also up to 10% by weight of biodegradable surfactant.

4. A composition according to claim 3, wherein the surfactant comprises calcium dodecyl benzene sulfonate.

5. A composition according to any preceding claim wherein the composition is essentially non-aqueous.

6. A composition according to any preceding claim in which about 55% to 90% (preferably 60 to 80%) by weight of the mixture is para-menthadienes, up to about 5% by weight of the mixture is of other terpene hydrocarbons and about 10% to 40% (preferably 10 to 35%) by weight of the mixture is terpene alcohols.

7. A composition according to any preceding claim in which the mixture constitutes at least 80% dry weight of the composition.

8. A composition according to any of claims 1 to 6 comprising up to 50% by weight of N-Methylpyrrolidone and at least 50% by weight of the said mixture.

9. Use of a composition according to any preceding claim as a solvent.